# EUROPEAN PATENT SPECIFICATION

(11) **EP 0 603 622 B1**
(45) Date of publication and mention of the grant of the patent: **25.02.1998**
(21) Application number: 93119605.9
(22) Date of filing: 06.12.1993
(51) Int. Cl.: H01L 29/45, H01L 21/336, H01L 29/786

(54) **Thin-film transistor array and method of fabricating the same**
Dünnfilm-Transistormatrix und deren Herstellungsverfahren
Matrice de transistor à couche mince et son procédé de fabrication

(30) Priority: 22.12.1992 JP 341836/92
(43) Date of publication of application: 29.06.1994
(73) Proprietor: MATSUSHITA ELECTRIC INDUSTRIAL CO., LTD., Kadoma-shi, Osaka-fu, 571 (JP)
(72) Inventor: Kobayashi, Ikunori, Osaka (JP); Takeda, Mamoru, Hirakata-shi Osaka (JP); Mino, Yoshiko, Settsu-shi, Osaka, (JP)
(74) Representative: Finsterwald, Manfred, Dipl.-Ing., Dipl.-Wirtsch.-Ing.

(56) References cited:
- EP-A- 0 211 402
- PATENT ABSTRACTS OF JAPAN vol. 16, no. 179 (P-1345) 28 April 1992 & JP-A-04 020 930 (NTT) 24 January 1992
- PATENT ABSTRACTS OF JAPAN vol. 17, no. 98 (P-1494) 26 February 1993 & JP-A-04 293 021 (TOSHIBA) 16 October 1992
- SOLID STATE TECHNOLOGY, vol.34, no.12, December 1991, USA pages 64 - 70 W.C. O'MARA
- PATENT ABSTRACTS OF JAPAN vol. 14, no. 105 (E-0895) 26 February 1990 & JP-A-01 307 280 (KONICA) 12 December 1989
- PATENT ABSTRACTS OF JAPAN vol. 16, no. 280 (E-1221) 23 June 1992 & JP-A-04 069 979 (HITACHI) 5 March 1992
- JOURNAL OF ELECTROCHEMICAL SOCIETY, vol.139, no.2, February 1992 pages 385 - 390 J.E.A.M. VAN DEN MEERAKKER ET AL.

## Description

### BACKGROUND OF THE INVENTION

### Field of the Invention

This invention relates to a thin-film transistor (TFT) device and a TFT array. This invention also relates to methods of fabricating a thin-film transistor (TFT) device and a TFT array.

### Description of the Prior Art

Typical liquid crystal displays have an array of transparent pixel electrodes for driving pixel-corresponding regions of liquid crystal. The transparent pixel electrodes are usually made of indium tin ode (ITO). In general, the transparent pixel electrodes are controlled by an array of thin-film transistors (TFT's) serving as switches.

In some of such liquid crystal displays, TFT source and drain electrodes include aluminum (Al) layers. A known method of fabricating a liquid crystal display of this type contains a photolithography-based patterning process using a negative-type photoresist which makes an original Al film into source and drain electrode Al layers of desired shapes. The patterning process follows the formation of ITO pixel electrodes. Generally, negative-type photolithography is worse than positive-type photolithography in processing accuracy.

In the known method of fabricating the liquid crystal display, if the negative-type photolithography is replaced by the positive-type photolithography, there occurs a problem as indicated below. Usually, positive-type photolithography uses alkaline liquid developer. In alkaline aqueous solution, since the oxidization potential of Al is lower (baser) than the reduction potential of ITO, oxidization-reduction tends to occur between Al and ITO. Thus, the ITO pixel electrodes tend to be reduced during the positive-type photolithography. Reduction of the ITO pixel electrodes results in corrosion thereof.

EP 0211402 discloses a method and a thin film transistor array according to the preambles of claims 1 and 3 respectively. Here, the corrosion of the ITO pixel electrode is prevented by an intermediate layer of insulating material between the ITO pixel electrode and the Al layer.

JP 4293021 discloses a method for manufacturing a TFT transistor using a laminated structure of chromium and aluminium during the manufacturing process for preventing the reduction of the ITO due to the electro-chemical reaction between Al and ITO, wherein in a subsequent process the upper chromium layer is etched away.

### SUMMARY OF THE INVENTION

It is a first object of this invention to provide an improved thin-film transistor (TFT) device.

It is a second object of this invention to provide an improved TFT array.

It is a third object of this invention to provide an improved method of fabricating a thin-film transistor (TFT) device.

It is a fourth object of this invention to provide an improved method of fabricating a TFT array.

These objects are achieved by a method according to claim 1 and a thin film transistor array according to claim 3.

### BRIEF DESCRIPTION OF THE DRAWINGS

Figs. 1(a)-1(g) are sectional views of a substrate and layers on the substrate which occur at various stages of the fabrication of a TFT array according to a first specific embodiment of this invention.

Fig. 2 is a diagram of cathodic polarization characteristics and anodic polarization characteristics of ITO and various metals in liquid developer.

Figs. 3(a)-3(e) are sectional views of a substrate and layers on the substrate which occur at various stages of the fabrication of a TFT array according to a second specific embodiment of this invention.

Fig. 4 is a sectional view of a portion of an TFT array.

### DESCRIPTION OF THE FIRST SPECIFIC PREFERRED EMBODIMENT

A liquid crystal display includes an array of transparent pixel electrodes, and an array of thin-film transistors (TFT's) electrically connected to the transparent pixel electrodes respectively. The transparent pixel electrodes are designed to drive pixel-corresponding regions of liquid crystal held within the display. The TFT's serve to control the transparent pixel electrodes respectively.

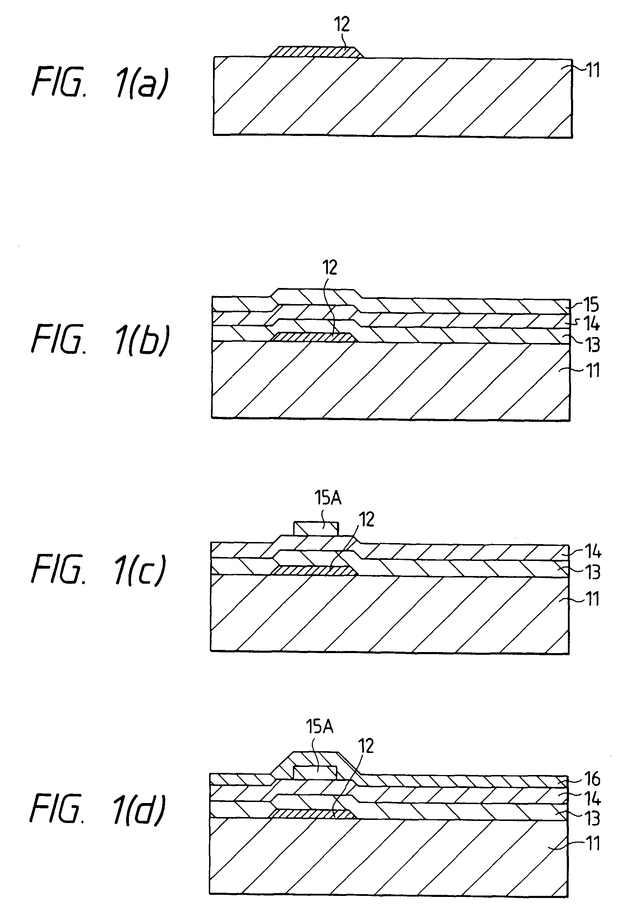

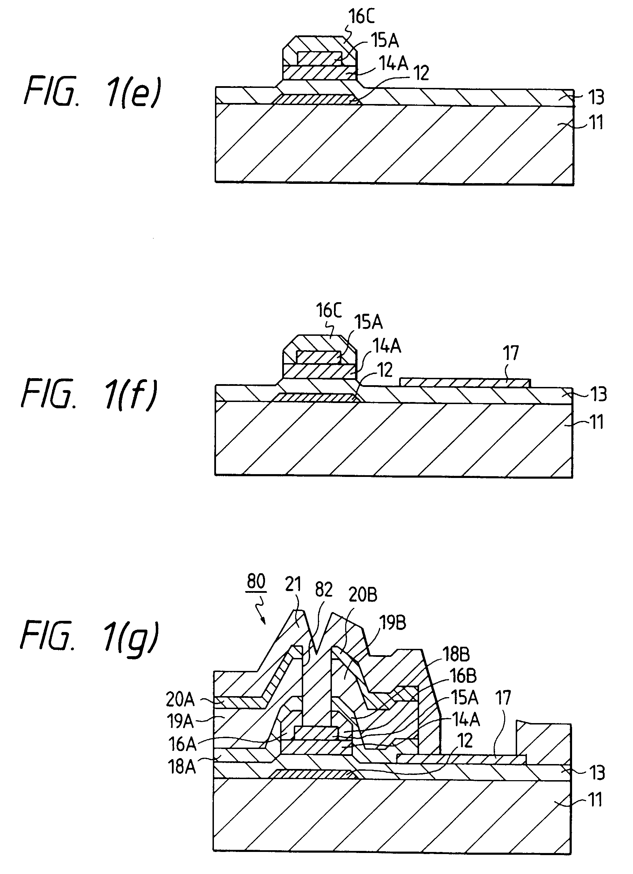

Fig. 1(g) shows one set of the thin-film transistor (TFT) and the transparent pixel electrode. In Fig. 1(g), the TFT and the transparent pixel electrode are denoted by the reference numerals "80" and "17" respectively.

As shown in Fig. 1(g), the TFT 80 and the transparent pixel electrode 17 are provided on a common transparent substrate 11 made of insulating material such as glass. The TFT 80 includes a gate electrode 12 extending on a given area of the transparent substrate 11. The gate electrode 12 is made of, for example, chromium (Cr). A gate insulating layer 13 extends on the gate electrode 12 and a portion of the transparent substrate 11.

The TFT 80 includes an amorphous silicon semiconductor region 14A extending on a given area of the gate insulating layer 13. The amorphous silicon semiconductor region 14A aligns with the gate electrode 12. A channel insulating protective region 15A extends on a central area of the amorphous silicon semiconductor region 14A. The channel insulating protective region 15A aligns with the gate electrode 12 and the amorphous silicon semiconductor region 14A.

Semiconductor regions 16A and 16B extend on edge portions of the amorphous silicon semiconductor region 14A which lie outward of the channel insulating protective region 15A. The semiconductor regions 16A and 16B are made of, for example, phosphorus-doped amorphous silicon having a conduction type "n+". The n+ amorphous silicon regions 16A and 16B cover sides of the channel insulating protective region 15A and upper surfaces of edge portions of the channel insulating protective region 15A.

The TFT 80 includes a source electrode composed of lower, intermediate, and upper metal layers 18A, 19A, and 20A. The lower metal layer 18A extends on the n+ amorphous silicon region 16A, a side of the amorphous silicon semiconductor region 14A, and a given area of the gate insulating layer 13. The intermediate metal layer 19A and the upper metal layer 20A are sequentially superposed on the lower metal layer 18A. The lower metal layer 18A is made of Ti (titanium) or Mo (molybdenum). The lower metal layer 18A serves as a barrier for preventing diffusion. The intermediate metal layer 19A is made of low-resistivity material such as aluminum (Al) or an aluminum alloy. The intermediate metal layer 19A forms a main portion of the source electrode. The upper metal layer 20A is made of Mo (molybdenum) or Ti (titanium). The source electrode is electrically connected to the n+ amorphous silicon region 16A. The n+ amorphous silicon region 16A provides ohmic contact between the source electrode and the amorphous silicon semiconductor region 14A.

The TFT 80 includes a drain electrode composed of lower, intermediate, and upper metal layers 18B, 19B, and 20B. The lower metal layer 18B extends on the n+ amorphous silicon region 16B, a side of the amorphous silicon semiconductor region 14A, and a given area of the gate insulating layer 13. The intermediate metal layer 19B and the upper metal layer 20B are sequentially superposed on the lower metal layer 18B. The lower metal layer 18B is made of Ti (titanium) or Mo (molybdenum). The lower metal layer 18B serves as a barrier for preventing diffusion. The intermediate metal layer 19B is made of low-resistivity material such as aluminum (Al) or an aluminum alloy. The intermediate metal layer 19B forms a main portion of the drain electrode. The upper metal layer 20B is made of Mo (molybdenum) or Ti (titanium). The drain electrode is electrically connected to the n+ amorphous silicon region 16B. The n+ amorphous silicon region 16B provides ohmic contact between the drain electrode and the amorphous silicon semiconductor region 14A.

The source electrode and the drain electrode are covered with a passivation layer 21. The source electrode and the drain electrode are separated from each other by a vertically-extending portion of the passivation layer 21. The n+ amorphous silicon regions 16A and 16B are also separated from each other by the vertically-extending portion of the passivation layer 21. The vertically-extending portion of the passivation layer 21 reaches an upper surface of the channel insulating protective region 15A.

The transparent pixel electrode 17 extends on a given area of the gate insulating layer 13 which is outwardly spaced from the amorphous silicon semiconductor region 14A. The transparent pixel electrode 17 is made of indium tin oxide (ITO). The transparent pixel electrode 17 is electrically connected to the drain electrode. An edge portion of the transparent pixel electrode 17 extends immediately below the lower metal layer 18B and the passivation layer 21 while a central portion of the transparent pixel electrode 17 is uncovered from the passivation layer 21.

As previously described, the source electrode, the drain electrode, and the transparent pixel electrode 17 extend on the given areas of the gate insulating layer 13 respectively. Thus, the source electrode, the drain electrode, and the transparent pixel electrode 17 extend on a common surface on the transparent substrate 11.

Regarding the upper metal layers 20A and 20B, Ti (titanium) or Mo (molybdenum) may be replaced by other metal such as W (tungsten) or Ta (tantalum) which has an oxidization potential higher than the reduction potential of ITO. It is preferable that the upper metal layers 20A and 20B have a thickness of 250 Å or greater.

The TFT array and the transparent pixel electrode array were fabricated as described below. It should be noted that a specific description will be given of only one set of a TFT and a transparent pixel electrode.

As shown In Fig. 1(a), a transparent substrate 11 was prepared. The transparent substrate 11 was made of insulating material such as glass. A metal film was formed on the transparent substrate 11. The metal film was made of, for example, chromium (Cr). The metal film was made into a TFT gate electrode 12 of a desired shape by a photography-based patterning process using a positive-type photoresist.

As shown in Fig. 1(b), a gate insulating layer 13, an amorphous silicon semiconductor layer 14, and a channel protective insulating layer 15 were sequentially formed on the gate electrode 12 and an exposed area of the transparent substrate 11 by a suitable process such as P-CVD (plasma chemical vapor deposition). Specifically, the gate insulating layer 13 extended on the gate electrode 12 and the transparent substrate 11. The amorphous silicon semiconductor layer 14 was superposed on the gate insulating layer 13. The channel protective insulating layer 15 was superposed on the amorphous silicon semiconductor layer 14.

As shown in Fig. 1(c), the channel protective insulating layer 15 was made into a channel protective insulating region 15A of a desired shape by a photolithography-based patterning process using a positive-type photoresist. The channel protective insulating region 15A aligned with the gate electrode 12.

As shown in Fig. 1(d), a semiconductor layer 16 was formed on the channel protective insulating region 15A and an exposed area of the amorphous silicon semiconductor layer 14 by a suitable process such as P-CVD (plasma chemical vapor deposition). The semiconductor layer 16 was made of, for example, phosphorus-doped amorphous silicon having a conduction type "n+".

As shown in Fig. 1(e), the amorphous silicon semiconductor layer 14 and the n+ amorphous silicon layer 16 were made into an amorphous silicon semiconductor region 14A of a desired shape and an n+ amorphous silicon region 16C of a desired shape by a photolithography-based patterning process using a positive-type photoresist. This patterning process uncovered portions of the gate insulating layer 13 which extended outward of the amorphous silicon semiconductor region 14A. The amorphous silicon semiconductor region 14A formed a TFT semiconductor region. The amorphous silicon semiconductor region 14A and the n+ amorphous silicon region 16C surrounded the channel protective insulating region 15A. The amorphous silicon semiconductor region 14A, the channel protective insulating region 15A, and the n+ amorphous silicon region 16C aligned with the gate electrode 12.

Subsequently, a film of indium tin oxide (ITO) was formed on an exposed area on the transparent substrate 11. As shown in Fig. 1(f), the ITO film was made into a transparent pixel electrode 17 of a desired shape by a photolithography-based patterning process using a positive-type photoresist. The transparent pixel electrode 17 extended on a portion of the gate insulating layer 13 which was outwardly spaced from the amorphous silicon semiconductor region 14A.

After the transparent pixel electrode 17 was made, a laminated or multilayer structure of lower, intermediate, and upper metal films was formed on an exposed area on the transparent substrate 11. Specifically, the lower metal film was formed on the n+ amorphous silicon region 16C, the transparent pixel electrode 17, and exposed areas of the amorphous silicon semiconductor region 14A and the gate insulating layer 13. Then, the intermediate and upper metal films were sequentially superposed on the lower metal film. The lower metal film was made of Ti (titanium) or Mo (molybdenum). The lower metal film was a barrier for preventing diffusion. The intermediate metal film was made of low-resistivity material such as aluminum (Al) or an aluminum alloy. The upper metal film was made of Mo (molybdenum) or Ti (titanium). As shown in Fig. 1(g), the lower, intermediate, and upper metal films were respectively made into lower metal layers 18A and 18B of desired shapes, intermediate metal layers 19A and 19B of desired shapes, and upper metal layers 20A and 20B of desired shapes by a photolithography-based patterning process using a positive-type photoresist. At the same time, the n+ amorphous silicon region 16C was made into two regions 16A and 16B of desired shapes. As a result of this patterning process, a groove 82 aligning with the amorphous silicon semiconductor region 14A was formed in the upper, intermediate, and upper metal films. A central area of the channel protective insulating region 15A was exposed at the bottom of the groove 82.

The lower metal layers 18A and 18B were spaced from each other. The intermediate metal layers 19A and 19B were spaced from each other. The upper metal layers 20A and 20B were spaced from each other. The n+ amorphous silicon regions 16A and 16B were spaced from each other. The intermediate metal layer 19A extended between the lower metal layer 18A and the upper metal layer 20A. The lower metal layer 18A, the intermediate metal layer 19A, and the upper metal layer 20A composed a TFT source electrode which was electrically connected to the n+ amorphous silicon region 16A. The n+ amorphous silicon region 16A provided ohmic contact between the source electrode and the amorphous silicon semiconductor region 14A. The intermediate metal layer 19A formed a main portion of the source electrode. The intermediate metal layer 19B extended between the lower metal layer 18B and the upper metal layer 20B. The lower metal layer 18B, the intermediate metal layer 19B, and the upper metal layer 20B composed a TFT drain electrode which was electrically connected to the n+ amorphous silicon region 16B and the transparent pixel electrode 17. The n+ amorphous silicon region 16B provided ohmic contact between the drain electrode and the amorphous silicon semiconductor region 14A. The intermediate metal layer 19B formed a main portion of the drain electrode.

Subsequently, a passivation film was formed on an exposed area on the transparent substrate 11. The passivation film was made of silicon nitride SiNx. As shown in Fig. 1(g), the passivation film was made into a passivation layer 21 of a desired shape by a patterning process. The passivation layer 21 covered the lower metal layers 18A and 18B, the intermediate metal layers 19A and 19B, the upper metal layers 20A and 20B, and the central area of the channel protective insulating region 15A. The passivation layer 21 filled the groove 82. Furthermore, the passivation layer 21 extended on a portion of the transparent pixel electrode 17. When the passive layer 21 was formed, a combination of the TFT and the transparent pixel electrode 17 was completed.

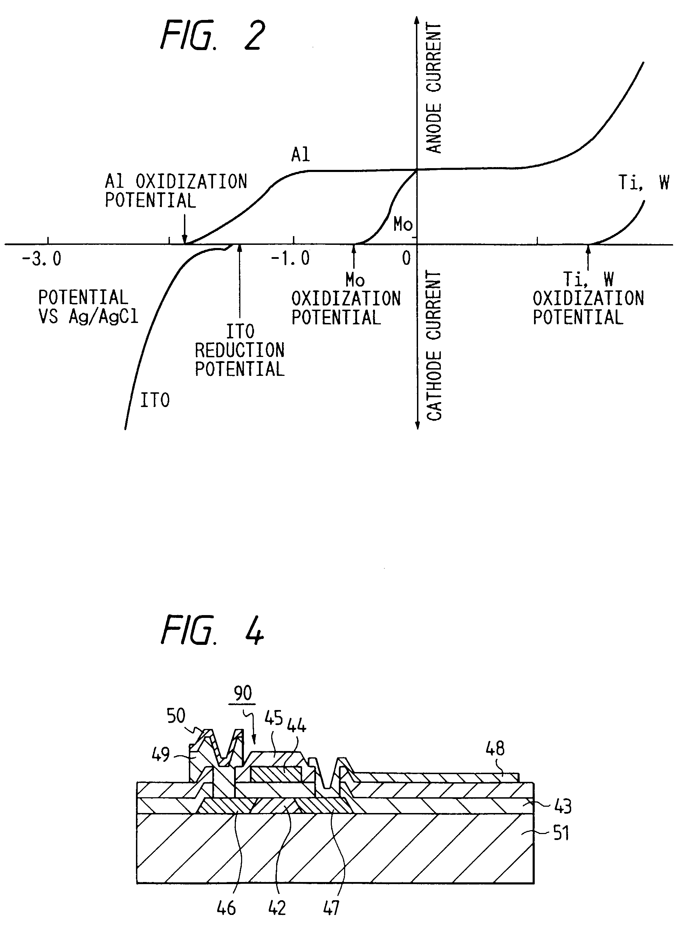

In alkaline aqueous solution, since the oxidization potential of Al is generally lower (baser) than the reduction potential of ITO as shown in Fig. 2, oxidization-reduction tends to occur between Al and ITO. Reduction of ITO results in corrosion thereof. In alkaline aqueous solution, since the anodic polarization potential of Mo (molybdenum) or Ti (titanium) is generally higher (nobler) than the cathodic polarization potential of ITO as shown in Fig. 2, cell reaction does not occur between ITO and Mo (molybdenum) or Ti (titanium).

The previously-mentioned patterning process to make the source electrode and the drain electrode (the lower metal layers 18A and 18B, the intermediate metal layers 19A and 19B, and the upper metal layers 20A and 20B) used liquid developer of the alkaline type. As previously described, the upper Ti or Mo film (corresponding to the upper metal layers 20A and 20B) extended on the intermediate Al or Al alloy film (corresponding to the intermediate metal layers 19A and 19B). During the patterning process to make the source electrode and the drain electrode, the upper Ti or Mo film separated the intermediate Al or Al alloy film from the alkaline liquid developer and thereby suppressed oxidization-reduction between the intermediate Al or Al alloy film and the ITO electrode 17. In addition, cell reaction did not occur between the upper Ti or Mo film and the ITO electrode 17 for the previously-mentioned reason. Accordingly, the ITO electrode 17 was prevented from corroding.

All the photolithography-based patterning processes in the fabrication of the TFT array and the transparent pixel electrode array used the positive-type photoresists. In general, positive-type photolithography has a high processing accuracy. Thus, the method of fabricating a TFT array and a transparent pixel electrode array according to this embodiment is advantageous in processing accuracy.

Regarding the upper metal film (corresponding to the upper metal layers 20A and 20B), Ti (titanium) or Mo (molybdenum) could be replaced by other metal such as W (tungsten) or Ta (tantalum) which had an oxidization potential higher than the reduction potential of ITO, or by an alloy containing at least two of Mo (molybdenum), Ti (titanium), W (tungsten), and Ta (tantalum). It was preferable that the upper Ti or Mo film (corresponding to the upper metal layers 20A and 20B) had a thickness of 250 Å or greater.

### DESCRIPTION OF THE SECOND SPECIFIC PREFERRED EMBODIMENT

A liquid crystal display includes an array of transparent pixel electrodes, and an array of thin-film transistors (TFT's) electrically connected to the transparent pixel electrodes respectively. The transparent pixel electrodes are designed to drive pixel-corresponding regions of liquid crystal held within the display. The TFT's serve to control the transparent pixel electrodes respectively.

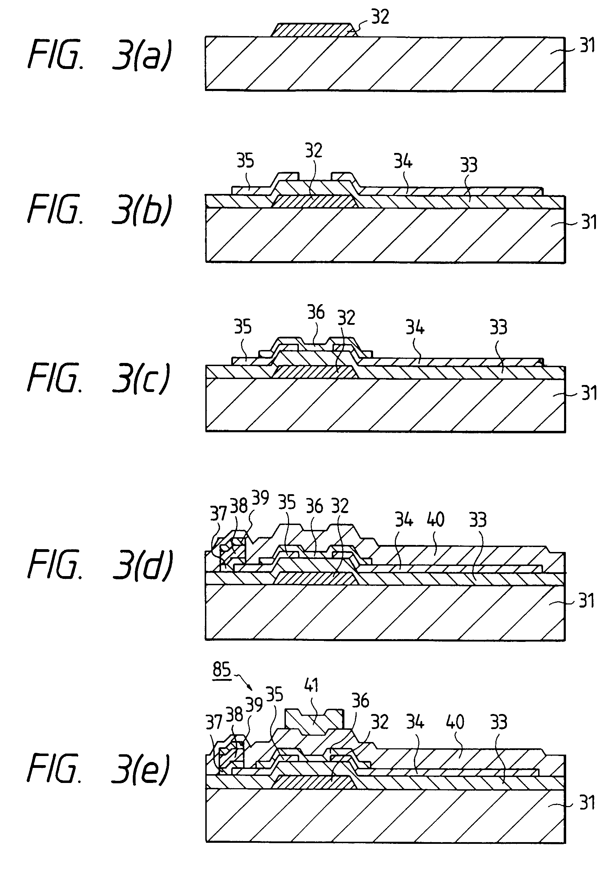

Fig. 3(e) shows one set of the thin-film transistor (TFT) and the transparent pixel electrode. In Fig. 3(e), the TFT and the transparent pixel electrode are denoted by the reference numerals "85" and "34" respectively.

As shown in Fig. 3(e), the TFT 85 and the transparent pixel electrode 34 are provided on a common transparent substrate 31 made of insulating material such as glass. The TFT 85 includes an optical shield or a light blocking layer 32 extending on a given area of the transparent substrate 31. Upper surfaces of the optical shield 32 and the transparent substrate 31 are covered with an inter-layer insulating film 33 of SiO₂.

The TFT 85 includes a source electrode 35 extending on a given area of the inter-layer insulating film 33. The source electrode 35 is made of ITO. The transparent pixel electrode 34 extends on a given area of the inter-layer insulating film 33. The transparent pixel electrode 34 is made of ITO. The source electrode 35 and the transparent pixel electrode 34 are spaced from each other by a groove which aligns with the optical shield 32. A portion of the transparent pixel electrode 34 which is close to the groove forms a drain electrode of the TFT 85. The inter-layer insulating film 33 is exposed at the groove.

An amorphous silicon semiconductor region 36 of an island configuration fills the groove between the transparent pixel electrode 34 and the source electrode 35, and extends on portions of the transparent pixel electrode 34 and the source electrode 35 which are adjacent to the groove. The amorphous silicon semiconductor region 36 aligns with the optical shield 32.

A laminated or multi-layer structure of lower, intermediate, and upper metal layers 37, 38, and 39 extends on given areas of the inter-layer insulating film 33 and the source electrode 35. The lower metal layer 37 is made of Mo (molybdenum). The intermediate metal layer 38 is made of low-resistivity material such as aluminum (Al) or an aluminum alloy. The upper metal layer 39 is made of Mo (molybdenum). The lower, intermediate, and upper metal layers 37, 38, and 39 compose a source wiring line of a multilayer configuration which is electrically connected to the source electrode 35. The source wiring line is spaced from the amorphous silicon semiconductor region 36.

As previously described, the source wiring line (the lower, intermediate, and upper metal layers 37, 38, and 39) and the transparent pixel electrode 34 extend on the given areas of the inter-layer insulating film 33. Thus, the source wiring line and the transparent pixel electrode 34 extend on a common surface on the transparent substrate 31.

Regarding the upper metal layer 39, Mo (molybdenum) may be replaced by other metal such as Ti (titanium), W (tungsten), Ta (tantalum) which has an oxidization potential higher than the reduction potential of ITO, or by an alloy containing at least two of Mo (molybdenum), Ti (titanium), W (tungsten), and Ta (tantalum). It is preferable that the upper metal layer 39 has a thickness of 250 Å or greater.

A gate insulating film 40 extends on the amorphous silicon semiconductor region 36, the source wiring line, and portions of the inter-layer insulating film 33, the transparent pixel electrode 34, and the source electrode 35. The TFT 85 includes a gate electrode 41 extending on a given area of the gate insulating film 40. The gate electrode 41 is made of Al. The gate electrode 41 aligns with the amorphous silicon semiconductor region 36 and the optical shield 32.

The TFT array and the transparent pixel electrode array were fabricated as described below. It should be noted that a specific description will be given of only one set of a TFT and a transparent pixel electrode.

As shown in Fig. 3(a), a transparent substrate 31 was prepared. The transparent substrate 31 was made of insulating material such as glass. A metal film of opaque material was formed on the transparent substrate 31. The metal film was made into an optical shield or a light blocking layer 32 of a desired shape by a photography-based patterning process using a positive-type photoresist.

As shown in Fig. 3(b), an inter-layer insulating film 33 of SiO₂ was formed on the optical shield 32 and an exposed area of the transparent substrate 31. A film of ITO was superposed on the inter-layer insulating film 33. The ITO film was made into a pixel electrode 34 and a TFT source electrode 35 by a photography-based patterning process using a positive-type photoresist. The source electrode 35 and the pixel electrode 34 were separated from each other by a groove which aligned with the optical shield 32. The inter-layer insulating film 33 was exposed at the groove. A portion of the pixel electrode 34 which was close to the groove formed a TFT drain electrode.

An amorphous silicon semiconductor film was formed on the pixel electrode 34, the source electrode 35, and an exposed area of the inter-layer insulating film 33 by a suitable process such as P-CVD (plasma chemical vapor deposition). As shown in Fig. 3(c), the amorphous silicon semiconductor film was made into an amorphous silicon semiconductor region 36 of a desired island shape by a photography-based patterning process using a positive-type photoresist. The amorphous silicon semiconductor region 36 filled the groove between the pixel electrode 34 and the source electrode 35, and extended on portions of the pixel electrode 34 and the source electrode 35 which were adjacent to the groove. The amorphous silicon semiconductor region 36 aligned with the optical shield 32.

After the amorphous silicon semiconductor region 36 was made, a laminated or multi-layer structure of lower, intermediate, and upper metal films was formed on an exposed area on the transparent substrate 11. Specifically, the lower metal film was formed on the amorphous silicon semiconductor region 36 and exposed areas of the inter-layer insulating film 33, the pixel electrode 34, and the source electrode 35. Then, the intermediate and upper metal films were sequentially superposed on the lower metal film. The lower metal film was made of Mo (molybdenum). The intermediate metal film was made of low-resistivity material such as aluminum (Al) or an aluminum alloy. The upper metal film was made of Mo (molybdenum). As shown in Fig. 3(d), the lower, intermediate, and upper metal films were respectively made into lower, intermediate, and upper metal layers 37, 38, and 39 of desired shapes by a photolithography-based patterning process using a positive-type photoresist.

The lower, intermediate, and upper metal layers 37, 38, and 39 composed a source wiring line of a multilayer configuration which was electrically connected to the source electrode 35. The source wiring line was spaced from the amorphous silicon semiconductor region 36. The source wiring line extended on a portion of the inter-layer insulating film 33 and an edge portion of the source electrode 35.

Subsequently, as shown in Fig. 3(d), a gate insulating film 40 was formed on an exposed area on the transparent substrate 31 by a suitable process such as P-CVD (plasma chemical vapor deposition). Specifically, the gate insulating film 40 extended on the amorphous silicon semiconductor region 36, the source wiring line, and portions of the inter-layer insulating film 33, the pixel electrode 34, and the source electrode 35.

A metal film of Al was formed on the gate insulating film 40. As shown in Fig. 3(e), the Al film was made into a TFT gate electrode 41 of a desired shape by a photolithography-based patterning process using a positive-type photoresist. The gate electrode 41 aligned with the amorphous silicon semiconductor region 36 and the optical shield 32. When the gate electrode 41 was formed, a combination of the TFT and the pixel electrode 34 was completed.

In alkaline aqueous solution, since the oxidization potential of Al Is generally lower (baser) than the reduction potential of ITO as shown in Fig. 2, oxidization-reduction tends to occur between Al and ITO. Reduction of ITO results in corrosion thereof. In alkaline aqueous solution, since the anodic polarization potential of Mo (molybdenum) or Ti (titanium) is generally higher (nobler) than the cathodic polarization potential of ITO as shown in Fig. 2, cell reaction does not occur between ITO and Mo (molybdenum) or Ti (titanium).

The previously-mentioned patterning process to make the source wiring line (the lower, intermediate, and upper metal layers 37, 38, and 39) used liquid developer of the alkaline type. As previously described, the upper Mo film (corresponding to the upper metal layer 39) extended on the intermediate Al or Al alloy film (corresponding to the intermediate metal layer 38). During the patterning process to make the source wiring line, the upper Mo film separated the intermediate Al or Al alloy film from the alkaline liquid developer and thereby suppressed oxidization-reduction among the intermediate Al or Al alloy film, the ITO source electrode 35, and the ITO pixel electrode 34. In addition, cell reaction did not occur among the upper Mo film and the ITO electrodes 34 and 35 for the previously-mentioned reason. Accordingly, the ITO electrodes 34 and 35 were prevented from corroding.

All the photolithography-based patterning processes in the fabrication of the TFT array and the transparent pixel electrode array used the positive-type photoresists. In general, positive-type photolithography has a high processing accuracy. Thus, the method of fabricating a TFT array and a transparent pixel electrode array according to this embodiment is advantageous in processing accuracy.

Regarding the upper metal film (corresponding to the upper metal layer 39), Mo (molybdenum) could be replaced by other metal such as Ti (titanium), W (tungsten), Ta (tantalum) which had an oxidization potential higher than the reduction potential of ITO. It was preferable that the upper Mo film (corresponding to the upper metal layer 39) had a thickness of 250 Å or greater.

### DESCRIPTION OF AN EXAMPLE OF A TFT-ARRAY

A liquid crystal display includes an array of transparent pixel electrodes, and an array of thin-film transistors (TFT's) electrically connected to the transparent pixel electrodes respectively. The transparent pixel electrodes are designed to drive pixel-corresponding regions of liquid crystal held within the display. The TFT's serve to control the transparent pixel electrodes respectively.

Fig. 4 shows one set of the thin-film transistor (TFT) and the transparent pixel electrode. In Fig. 4, the TFT and the transparent pixel electrode are denoted by the reference numerals "90" and "48" respectively.

As shown in Fig. 4, the TFT 90 and the transparent pixel electrode 48 are provided on a common transparent substrate 51 made of insulating material such as glass. The TFT 90 includes a polycrystalline silicon semiconductor region 42, a source region 46, and a drain region 47 extending on given areas of the transparent substrate 51. The polycrystalline silicon semiconductor region 42 is sandwiched between the source region 46 and the drain region 47.

Upper surfaces of the polycrystalline silicon semiconductor region 42, the source region 46, the drain region 47, and the transparent substrate 51 are covered with a TFT gate insulating film 43 having holes or apertures directly extending above the source region 46 and the drain region 47. The gate insulating film 43 is made of SiO₂. The TFT 90 includes a gate electrode 44 extending on a given area of the gate insulating film 43. The gate electrode 44 aligns with the polycrystalline silicon semiconductor region 42.

Upper surfaces of the gate electrode 44 and the gate insulating film 43 are covered with an inter-layer insulating film 45 made of SiO₂. The inter-layer insulating film 45 has holes or apertures aligning with the holes in the gate insulating film 43.

The transparent pixel electrode 48 is made of ITO. The transparent pixel electrode 48 extends on given areas of the inter-layer insulating film 45 and the drain region 47. The pixel electrode 48 fills the apertures in the gate insulating film 43 and the inter-layer insulating film 45 above the drain region 47, and extends outward of the gate electrode 44. The pixel electrode 48 is electrically connected to the drain region 47. The pixel electrode 48 is separated from the gate electrode 44 by the inter-layer insulating film 45.

An Al layer 49 and an Mo layer 50 compose a source wiring line of a multilayer or laminated configuration which is electrically connected to the source region 46. The Al layer 49 fills the apertures in the gate insulating film 43 and the inter-layer insulating film 45 above the source region 46, and extends on a portion of the inter-layer insulating film 45 around the apertures. The Al layer 49 is separated from the gate electrode 44 by the inter-layer insulating film 45. The Mo layer 50 extends on and overlaps with the Al layer 49.

Regarding the Mo layer 50, Mo (molybdenum) may be replaced by other metal such as Ti (titanium), W (tungsten), Ta (tantalum) which has an oxidization potential higher than the reduction potential of ITO, or by an alloy containing at least two of Mo (molybdenum), Ti (titanium), W (tungsten), and Ta (tantalum). It is preferable that the Mo layer 50 has a thickness of 250 Å or greater.

The TFT array and the transparent pixel electrode array were fabricated as described below. It should be noted that a specific description will be given of only one set of a TFT and a transparent pixel electrode.

As shown in Fig. 4, a transparent substrate 51 was prepared. The transparent substrate 51 was made of insulating material such as glass. A semiconductor film of polycrystalline silicon was formed on the transparent substrate 51. The semiconductor film was made into a polycrystalline silicon semiconductor layer of a desired shape by a photography-based patterning process using a positive-type photoresist. A TFT gate insulating film 43 of SiO₂ was formed on the polycrystalline silicon semiconductor layer and an exposed area of the transparent substrate 51 by a suitable process such as LPCVD (low pressure chemical vapor deposition).

A TFT gate electrode 44 was formed on a given area of the gate insulating film 43. The gate electrode 44 aligned with the polycrystalline silicon semiconductor layer. An inter-layer insulating film 45 of SiO₂ was formed on the gate electrode 44 and an exposed area of the gate insulating film 43.

Portions of the gate insulating film 43 and the inter-layer insulating film 45, which extended directly above edge regions of the polycrystalline silicon semiconductor layer, were removed to provide holes or grooves in the gate insulating film 43 and the inter-layer insulating film 45. The grooves were separated outwardly from the gate electrode 44 by the inter-layer insulating film 45. The polycrystalline silicon semiconductor layer was exposed at the bottoms of the grooves. Phosphorus ions were implanted into the edge regions of the polycrystalline silicon semiconductor layer via the grooves to change the edge regions into a TFT source region 46 and a TFT drain region 47. The intermediate region of the polycrystalline silicon semiconductor layer between the edge regions was not exposed to ion implantation, and consequently remained as a TFT polycrystalline silicon semiconductor region 42. In this way, the TFT source region 46, the TFT drain region 47, and the TFT polycrystalline silicon semiconductor region 42 were made. The polycrystalline silicon semiconductor region 42 extended between the source region 46 and the drain region 47. In addition, the polycrystalline silicon semiconductor region 42 aligned with the gate electrode 44.

A transparent pixel electrode 48 of ITO was formed on given areas of the inter-layer insulating film 45 and the drain region 47. The pixel electrode 48 filled the groove above the drain region 47, and extended outward of the gate electrode 44. The pixel electrode 48 was electrically connected to the drain region 47. The pixel electrode 48 was separated from the gate electrode 44 by the inter-layer insulating film 45.

After the pixel electrode 48 was formed, an Al film was formed on an exposed area on the transparent substrate 51. The Al film filled the groove above the source region 46. The Al film was electrically connected to the source region 46. An Mo film was superposed on the Al layer. The Al film and the Mo film were made into an Al layer 49 and an Mo layer 50 of desired shapes by a photography-based patterning process using a positive-type photoresist. The Mo layer 50 overlapped the Al layer 49. The Al layer 49 and the Mo layer 50 composed a source wiring line of a multilayer or laminated configuration which was electrically connected to the source region 46. The Al layer 49 filled the groove above the source region 46, and extended on a portion of the inter-layer insulating film 45 around the groove. The Al layer 49 was separated from the gate electrode 44 by the inter-layer insulating film 45. When the source wiring line was formed, a combination of the TFT and the pixel electrode 48 was completed.

In alkaline aqueous solution, since the oxidization potential of Al is generally lower (baser) than the reduction potential of ITO as shown in Fig. 2, oxidization-reduction tends to occur between Al and ITO. Reduction of ITO results in corrosion thereof. In alkaline aqueous solution, since the anodic polarization potential of Mo (molybdenum) or Ti (titanium) is generally higher (nobler) than the cathodic polarization potential of ITO as shown in Fig. 2, cell reaction does not occur between ITO and Mo (molybdenum) or Ti (titanium).

The previously-mentioned patterning process to make the source wiring line (the Al layer 49 and the Mo layer 50) used liquid developer of the alkaline type. As previously described, the Mo film (corresponding to the Mo layer 50) extended on the Al film (corresponding to the Al layer 49). During the patterning process to make the source wiring line, the Mo film separated the Al film from the alkaline liquid developer and thereby suppressed oxidization-reduction among the Al film and the ITO pixel electrode 48. In addition, cell reaction did not occur among the Mo film and the ITO pixel electrode 48 for the previously-mentioned reason. Accordingly, the ITO pixel electrode 48 was prevented from corroding.

All the photolithography-based patterning processes in the fabrication of the TFT array and the transparent pixel electrode array used the positive-type photoresists. In general, positive-type photolithography has a high processing accuracy. Thus, the method of fabricating a TFT array and a transparent pixel electrode array according to this example is advantageous in processing accuracy.

Regarding the Mo film (corresponding to the Mo layer 50), Mo (molybdenum) could be replaced by other metal such as Ti (titanium), W (tungsten), Ta (tantalum) which had an oxidization potential higher than the reduction potential of ITO, or by an alloy containing at least two of Mo (molybdenum), Ti (titanium), W (tungsten), and Ta (tantalum). It was preferable that the Mo film (corresponding to the Mo layer 50) had a thickness of 250 Å or greater.

## Claims

1. Method of fabricating a thin-film transistor array, comprising the steps of:
forming an electrically conductive portion (17, 35) on a substrate (11, 31), the electrically conductive portion (17, 35) being made of one of indium tin oxide, indium oxide and tin oxide;
processing the electrically conductive portion (17, 35) by photolithography;
forming first and second metal layers (19A, 19B, 20A, 20B; 38, 39), the first metal layer (19A, 19B; 38) being made of one of aluminium and an aluminium alloy, the second metal layer (20A, 20B; 39) being formed on the first metal layer (19A,19B; 38) and being made of metal having an oxidation potential nobler than a reduction potential of said one of indium tin oxide, indium oxide and tin oxide in alkaline aqueous solution; and
processing the first and second metal layers (19A, 19B, 20A, 20B; 38, 39) to form a part of a source or drain electrode or a source or drain wire;
characterised in that
the first and second metal layers (19A, 19B, 20A, 20B; 38, 39) are formed such that they extend onto the electrically conductive portion (17, 35),
the first and second metal layers (19A, 19B, 20A, 20B; 38, 39) are processed by positive-type photolithography using an alkaline liquid developer, and the first metal layer (19A, 19B; 38) and the second metal layer (20A, 20B; 39) are processed in a single patterning process, the second metal layer (20A, 20B; 39) serving as a separating layer for the first metal layer (19A, 19B; 38) during the photolithography process separating the first metal layer from the alkaline liquid developer.

2. Method according to claim 1,
characterised by the further step of forming a third metal layer (18A, 18B; 37) for preventing diffusion, the third metal layer (18A, 18B; 37) being formed below the first metal layer (19A, 19B; 38).

3. A thin-film transistor array comprising:
a substrate (11, 31, 51);
an electrically conductive portion (17, 35) made of one of indium tin oxide, indium oxide, and tin oxide; and
a metal layer (19A, 19B, 20A, 20B; 38, 39) forming at least a part of a source or drain electrode or of a source or drain wire;
wherein the electrically conductive portion (17, 35) and the metal layer (19A, 19B, 20A, 20B; 38, 39) are formed on a common surface of the substrate (11, 31); the metal layer (19A, 19B, 20A, 20B; 38, 39) includes a first layer (19A, 19B; 38) and a second layer (20A, 20B; 39); the first layer (19A, 19B; 38) is made of one of aluminium and aluminium alloy; the second layer (20A, 20B; 39) is formed on the first layer (19A, 19B, 38) and made of metal having an oxidation potential nobler than a reduction potential of said one of indium tin oxide, indium oxide and tin oxide in alkaline aqueous solution for a positive-type photoresist;
characterised in that the first layer (19A, 19B; 38) and the second layer (20A, 20B; 39) extend onto the electrically conductive portion (17, 35).

4. The thin-film transistor array of claim 3
characterised in that the metal layer further includes a third layer (18A, 18B; 37) for preventing diffusion, the third layer (18A, 18B; 37) being formed below the first layer (19A, 19B; 38).

5. The thin-film transistor array of claim 3,
characterised in that the second layer (20A, 20B; 39) is made of molybdenum.

## Patentansprüche

1. Verfahren zur Herstellung einer Dünnfilm-Transistoranordnung mit den Schritten, daß:
ein elektrisch leitfähiger Teil (17, 35) auf einem Substrat (11, 31) gebildet wird, wobei der elektrisch leitfähige Teil (17, 35) aus einem von Indiumzinnoxid, Indiumoxid und Zinnoxid hergestellt wird;
der elektrisch leitfähige Teil (17, 35) durch Photolithographie verarbeitet wird;
erste und zweite Metallschichten (19A, 19B, 20A, 20B; 38, 39) gebildet werden, wobei die erste Metallschicht (19A, 19B; 38) aus einem von Aluminium und einer Aluminiumlegierung hergestellt wird, die zweite Metallschicht (20A, 20B; 39) auf der ersten Metallschicht (19A, 19B; 38) gebildet und aus Metall hergestellt wird, das in alkalischer wäßriger Lösung ein edleres Oxidationspotential als ein Reduktionspotential des einen von Indiumzinnoxid, Indiumoxid und Zinnoxid aufweist; und daß
die ersten und zweiten Metallschichten (19A, 19B, 20A, 20B; 38, 39) verarbeitet werden, um einen Teil einer Source- oder Drain-Elektrode oder eine Source- oder Drain-Leitung zu bilden;
dadurch **gekennzeichnet,** daß
die ersten und zweiten Metallschichten (19A, 19B, 20A, 20B; 38, 39) derart gebildet werden, daß sie sich auf dem elektrisch leitfähigen Teil (17, 35) erstrecken, daß
die ersten und zweiten Metallschichten (19A, 19B, 20A, 20B; 38, 39) durch Photolithographie von der Positiv-Sorte unter Verwendung eines alkalischen, flüssigen Entwicklers verarbeitet werden, und daß die erste Metallschicht (19A, 19B; 38) und die zweite Metallschicht (20A, 20B; 39) in einem einzigen Musterungsprozeß verarbeitet werden, wobei die zweite Metallschicht (20A, 20B; 39) als eine Trennschicht für die erste Metallschicht (19A, 19B; 38) während des Photolithographieprozesses dient, die die erste Metallschicht von dem alkalischen, flüssigen Entwickler trennt.

2. Verfahren nach Anspruch 1,
gekennzeichnet durch den weiteren Schritt, daß eine dritte Metallschicht (18A, 18B; 37) gebildet wird, um Diffusion zu verhindern, wobei die dritte Metallschicht (18A, 18B; 37) unter der ersten Metallschicht (19A, 19B; 38) gebildet wird.

3. Dünnfilm-Transistoranordnung, umfassend:
ein Substrat (11, 31, 51);
einen elektrisch leitfähigen Teil (17, 35), der aus einem von Indiumzinnoxid, Indiumoxid und Zinnoxid hergestellt ist; und
eine Metallschicht (19A, 19B, 20A, 20B; 38, 39), die wenigstens einen Teil einer Source- oder Drain-Elektrode oder einer Source- oder Drain-Leitung bildet;
wobei der elektrisch leitfähige Teil (17, 35) und die Metallschicht (19A, 19B, 20A, 20B; 38, 39) auf einer gemeinsamen Oberfläche des Substrates (11, 31) gebildet sind; die Metallschicht (19A, 19B, 20A, 20B; 38, 39) eine erste Schicht (19A, 19B; 38) und eine zweite Schicht (20A, 20B; 39) umfaßt; die erste Schicht (19A, 19B; 38) aus einem von Aluminium und einer Aluminiumlegierung hergestellt ist; die zweite Schicht (20A, 20B; 39) auf der ersten Schicht (19A, 19B, 38) gebildet und aus Metall hergestellt ist, das in alkalischer wäßriger Lösung ein edleres Oxidationspotential als ein Reduktionspotential von dem einen von Indiumzinnoxid, Indiumoxid und Zinnoxid für einen Photoresist von der Posititv-Sorte aufweist;
dadurch **gekennzeichnet,** daß
die erste Schicht (19A, 19B; 38) und die zweite Schicht (20A, 20B; 39) sich auf dem elektrisch leitfähigen Teil (17, 35) erstrecken.

4. Dünnfilm-Transistoranordnung nach Anspruch 3,
dadurch **gekennzeichnet,** daß die Metallschicht ferner eine dritte Schicht (18A, 18B; 37) umfaßt, um Diffusion zu verhindern, wobei die dritte Schicht (18A, 18B; 37) unter der ersten Schicht (19A, 19B; 38) gebildet ist.

5. Dünnfilm-Transistoranordung nach Anspruch 3,
dadurch **gekennzeichnet,** daß die zweite Schicht (20A, 20B; 39) aus Molybdän hergestellt ist.

## Revendications

1. Procédé pour fabriquer un réseau de transistors à couche mince, comprenant les étapes consistant à
former une partie conductrice de l'électricité (17, 35) sur un substrat (11, 31), la partie conductrice de l'électricité (17, 35) étant constituée d'un oxyde d'indium et d'étain, ou d'un oxyde d'indium ou d'un oxyde d'étain;
traiter la partie conductrice de l'électricité (17, 35) par photolithographie;
former des première et seconde couches métalliques (19A, 19B, 20A, 20B; 38, 39), la première couche métallique (19A, 19B; 38) étant constituée d'aluminium ou d'un alliage d'aluminium, la seconde couche métallique (20A, 20B; 39) étant formée sur la première couche métallique (19A, 19B; 38) et étant constituée d'un métal ayant un potentiel d'oxydation plus noble que le potentiel de réduction dudit oxyde d'indium et d'étain, ou dudit oxyde d'indium ou dudit oxyde d'étain dans une solution aqueuse alcaline; et
traiter les première et seconde couches métalliques (19A, 19B, 20A, 20B; 38, 39) afin de former une partie d'une électrode de source ou de drain ou un fil de source ou de drain;
caractérisé en ce que
les première et seconde couches métalliques (19A, 19B, 20A, 20B ; 38, 39) sont formées de façon à s'étendre sur la partie conductrice de l'électricité (17, 35);
les première et seconde couches métalliques (19A, 19B, 20A, 20B; 38, 39) sont traitées par photolithographie du type positif utilisant un révélateur alcalin liquide, et la première couche métallique (19A, 19B; 38) et la seconde couche métallique (20A, 20B; 39) sont traitées dans une opération unique de mise en motif, la seconde couche métallique (20A, 20B; 39) servant de couche de séparation pour la première couche métallique (19A, 19B; 38) pendant l'opération de photolithographie séparant la première couche métallique du révélateur alcalin liquide.

2. Procédé selon la revendication 1,
caractérisé par l'étape supplémentaire consistant à former une troisième couche métallique (18A, 18B; 37) pour éviter la diffusion, la troisième couche métallique (18A, 18B; 37) étant formée au-dessous de la première couche métallique (19A, 19B; 38).

3. Réseau de transistors à couche mince comprenant :
un substrat (11, 31, 51);
une partie conductrice de l'électricité (17, 35) constituée d'un oxyde d'indium et d'étain ou d'un oxyde d'indium ou d'un oxyde d'étain; et
une couche métallique (19A, 19B, 20A, 20B; 38, 39) formant au moins une partie d'une électrode de source ou de drain ou d'un fil de source ou de drain;
dans lequel la partie conductrice de l'électricité (17, 35) et la couche métallique (19A, 19B, 20A, 20B; 38, 39) sont formées sur une surface commune du substrat (11, 31); la couche métallique (19A, 19B, 20A, 20B; 38, 39) comprend une première couche (19A, 19B; 38) et une seconde couche (20A, 20B; 39); la première couche (19A, 19B; 38) est constituée d'aluminium ou d'un alliage d'aluminium; la seconde couche (20A, 20B; 39) est formée sur la première couche (19A, 19B, 38) et est constituée d'un métal ayant un potentiel d'oxydation plus noble que le potentiel de réduction dudit oxyde d'indium et d'étain ou dudit oxyde d'indium ou dudit oxyde d'étain en solution alcaline aqueuse pour un agent photorésistant du type positif;
caractérisé en ce que la première couche (19A, 19B; 38) et la seconde couche (20A, 20B; 39) s'étendent sur la partie conductrice de l'électricité (17, 35).

4. Réseau de transistors à couche mince selon la revendication 3, caractérisé en ce que la couche métallique comporte en outre une troisième couche (18A, 18B; 37) pour éviter la diffusion, la troisième couche (18A, 18B; 37) étant formée au-dessous de la première couche (19A, 19B; 38).

5. Réseau de transistors à couche mince selon la revendication 3, caractérisé en ce que la seconde couche (20A, 20B; 39) est constituée de molybdène.
